Europäisches Patentamt

European Patent Office

Office européen des brevets

(19)

(11) **EP 1 708 550 A1**

(12) **EUROPEAN PATENT APPLICATION**

(43) Date of publication:
**04.10.2006 Bulletin 2006/40**

(51) Int Cl.:
***H05K 1/02*** *(2006.01)*

(21) Application number: **06005189.3**

(22) Date of filing: **14.03.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **31.03.2005 JP 2005103995**

(71) Applicant: **TDK Corporation
Chuo-ku,
Tokyo 103-8272 (JP)**

(72) Inventor: **Ikeda, Hiroshi
Tokyo 103-8272 (JP)**

(74) Representative: **Degwert, Hartmut
Prinz & Partner GbR
Rundfunkplatz 2
80335 München (DE)**

(54) **Electronic circuit**

(57)      The present invention provides electric circuits (100) in which the line width of a conductor (11), which becomes close to a metal flange (16) of a connector (15) or a conductor wall (21), is gradually reduced from a predetermined position thereon, thereby the reduction of the impedance of the conductor line (11) can be compensated.

Fig.1

**Description**

BACKGROUND OF THE INVENTION

1. Field of the Invention

The present invention relates to electronic circuits capable of preventing the degradation of signal propagating characteristics due to the change of the impedance characteristics of conductor lines provided on the upper surface of a substrate.

2. Description of the related art

Electronic circuits including conductor lines formed on a substrate are housed in metal cases to isolate respective circuit blocks from one another or are provided with conductor walls for the respective circuit blocks to electromagnetically isolate the respective circuit blocks from one another.

Further, there are provided connectors for outputting signals from the conductor lines formed on the substrate to the outside and for inputting signals from the outside to the conductor lines so that the conductor lines are electrically connected to the connectors. The center conductors of the connectors have a diameter smaller than the line widths of the conductor lines and, therefore, if the conductor lines are connected to the center conductors of the connectors, this will cause impedance mismatching at the connection points therebetween. Therefore, there has been disclosed a technique for reducing the line width of a conductor line to be equal to the diameter of a center conductor for enabling connection therebetween (for example, refer to Microwave Filers, Impedance-Matching Networks, And Coupling Structures, P. 475, 1980, ARTECH HOUSE BOOKS).

SUMMARY OF THE INVENTION

When a conductor line becomes close to a metal flange of a connector or a conductor wall, the impedance of the conductor line is reduced due to the influences of the conductor. The reduction of the impedance of the conductor line causes impedance mismatching, which induces reflection at the portion having the reduced impedance, thus resulting in degradation of signal propagating characteristics.

However, the aforementioned technique for reducing the line width of a conductor line to be equal to the diameter of a center conductor for enabling connection therebetween is a technique for attaining impedance matching between the conductor line and the connector. Therefore, this technique can not alleviate the influences of metal flanges of connectors and conductor walls. Particularly, in cases where signals having higher frequencies are employed, greater parts of signals are influenced thereby, relative to the wavelengths of the signals, which increases the influences of the reduction of the impedance of the conductor line induces, thus resulting in significant degradation of the signal propagating characteristics.

It is an object of the present invention to provide electronic circuits capable of alleviating the degradation of signal propagating characteristics due to the influences of the metal flanges of connectors or conductor walls, even when conductor lines formed on the upper surface of a substrate are connected to the connectors or pass through through-holes provided through the conductor walls.

In order to attain the aforementioned object, the present invention provides electric circuits in which the line width of a conductor, which becomes close to a metal flange of a connector or a conductor wall, is gradually reduced from a predetermined position thereon, thereby the reduction of the impedance of the conductor line can be alleviated.

More specifically, a first aspect of the present invention is an electronic circuit including a substrate made of a dielectric, a conductor line provided on the upper surface of the substrate, a coaxial connector connected to the end portion of the conductor line in the direction of signal propagation and a conductor wall to which the connector is mounted, wherein the line width of the conductor line is gradually reduced to be smaller than the specific line width of the conductor line which is determined by a set impedance of the conductor line from a predetermined position thereon as the conductor line becomes close to the aforementioned end portion.

With the present invention, by gradually reducing the line width of the conductor line as the conductor line becomes close to its end portion which is connected to the connector in the direction of propagation, the reduction of the impedance of the conductor line can be compensated.

When the connector includes a metal flange and the metal flange becomes close to the substrate on which the conductor line is provided, the metal flange forms the conductor wall according to the first aspect of the present invention.

Preferably, in the first aspect of the present invention, a gap is provided between the aforementioned end portion and the conductor wall such that the distance between the aforementioned end portion and the conductor wall is in the range of 3% or more to 10% or less of the specific line width of the conductor line which is determined by the set impedance of the conductor line.

By providing a gap between the end portion of the conductor line and the conductor wall, it is possible to enhance the effect of compensating for the reduction of the impedance of the conductor line.

Preferably, in the first aspect of the present invention, the line width of the aforementioned end portion of the conductor line is within the range of 80% or more to 90% or less of the specific line width of the conductor line which is determined by the set impedance of the conductor line.

By setting the line width of the conductor line to be equal to or less than 90% of the specific line width of the conductor line which is determined by the set impedance of the conductor line, it is possible to compensate for the reduction of the impedance of the conductor line. If the line width of the conductor line is set to be smaller than 80% of the specific line width of the conductor line, this will cause over-compensation for the impedance of the conductor line, thus resulting in an increase of the impedance of the conductor line. Accordingly, it is preferable that the line width of the conductor line is within the range of 80% or more to 90% or less of the specific line width of the conductor line which is determined by the set impedance of the conductor line.

In the first aspect of the present invention, the distance between the aforementioned end portion of the conductor line and the aforementioned predetermined position is preferably equal to or greater than one-half of the difference between the specific line width of the conductor line which is determined by the set impedance of the conductor line and the line width of the aforementioned end portion and is more preferably equal to or greater than the specific line width of the conductor line which is determined by the set impedance of the conductor line.

It is preferable that the reduction of the line width of the conductor line is started from a position as far from the conductor wall as possible however, when the distance between the predetermined position at which the reduction of the line width of the conductor line is started and the end portion of the conductor line is equal to or greater than one-half of the difference between the specific line width of the conductor line which is determined by the set impedance of the conductor line and the line width of the aforementioned end portion, it is possible to stably compensate for the reduction of the impedance of the conductor line. Further, when the aforementioned distance is equal to or greater than the specific line width of the conductor line which is determined by the set impedance of the conductor line, it is possible to compensate for the reduction of the impedance of the conductor line with higher stability.

A second aspect of the present invention is an electronic circuit including a substrate made of a dielectric, a conductor line provided on the upper surface of the substrate and a conductor wall straddling the conductor line, wherein the line width of the conductor line is gradually reduced to be smaller than the specific line width of the conductor line which is determined by a set impedance of the conductor line from a predetermined position thereon as the conductor line becomes close to the conductor wall and the portion of the conductor line which is straddled by the conductor wall has a constant line width.

With the present invention, the line width of the conductor line is gradually reduced from a predetermined position as the conductor line becomes close to the conductor wall, which can compensate for the reduction of the impedance of the conductor line. Further, the conductor line is formed to have a reduced line width at its portion passed through a through hole provided through the conductor wall, which can compensate for the reduction of the impedance of the conductor line.

Preferably, in the second aspect of the present invention, the conductor line has a line width within the range of 80% or more to 90% or less of the specific line width of the conductor line which is determined by the set impedance of the conductor line, at a portion straddled by the conductor wall.

By setting the line width of the portion of the conductor line which is straddled by the conductor wall to be equal to or less than 90% of the specific line width of the conductor line which is determined by the set impedance of the conductor line, it is possible to compensate for the reduction of the impedance of the conductor line. If the aforementioned line width is set to be smaller than 80% of the specific line width of the conductor line, this will result in an increase of the impedance of the conductor line. Accordingly, it is preferable that the line width of the conductor line is set to within the range of 80% or more to 90% or less of the specific line width of the conductor line.

In the second aspect of the present invention, the distance between the conductor wall and the aforementioned predetermined position is preferably equal to or greater than one-half of the difference between the specific line width of the conductor line which is determined by the set impedance of the conductor line and the line width of the portion of the conductor line which is straddled by the conductor wall and is more preferably equal to or greater than the specific line width of the conductor line which is determined by the set impedance of the conductor line.

It is preferable that the reduction of the line width of the conductor line is started from a position as far from the conductor wall as possible however, when the distance between the predetermined position at which the reduction of the line width of the conductor line is started and the conductor wall is equal to or greater than one-half of the difference between the specific line width of the conductor line which is determined by the set impedance of the conductor line and the line width of the portion of the conductor line which is straddled by the conductor wall, it is possible to stably compensate for the reduction of the impedance of the conductor line. Further, when the aforementioned distance is equal to or greater than the specific line width of the conductor line which is determined by the set impedance of the conductor line, it is possible to compensate for the reduction of the impedance of the conductor line with higher stability.

The aforementioned inventions can be arbitrarily combined.

The electronic circuits according to the present invention can alleviate the degradation of signal propagating characteristics due to the influences of metal flanges of connectors or conductor walls, even when conductor lines formed on the upper surface of a substrate are connected to the connectors or pass through through-holes provided through the conductor walls.

BRIEF DESCRIPTION OF THE DRAWINGS

Fig. 1 is a top view of an electronic circuit 100 for explaining an embodiment of the present invention as an example.

Fig. 2 is a top view of an electronic circuit 200 for explaining another embodiment of the present invention as an example.

Fig. 3 is a top view illustrating, in an enlarged manner, the portion at which a micro-strip line and the center conductor of the coaxial connector are connected to each other.

Fig. 4 is a top view of an electronic circuit for explaining an embodiment of another invention of the present application as an example.

Fig. 5 is a top view illustrating, in an enlarged manner, the portion at which the micro-strip line is passed through the through hole provided through the conductor wall.

Description of the Reference Numerals

10: substrate
11: micro-strip line
15 : coaxial connector
16 : metal flange
17 : center conductor
18 : inter-electrode dielectric
21 : conductor wall
22 : conductor wall
23 : through hole
100, 200 and 300 : electronic circuits

DESCRIPTION OF PREFERRED EMBODIMENTS

Hereinafter, embodiments of the present invention will be described with reference to the drawings. However, the present invention is not limited to the following embodiments.

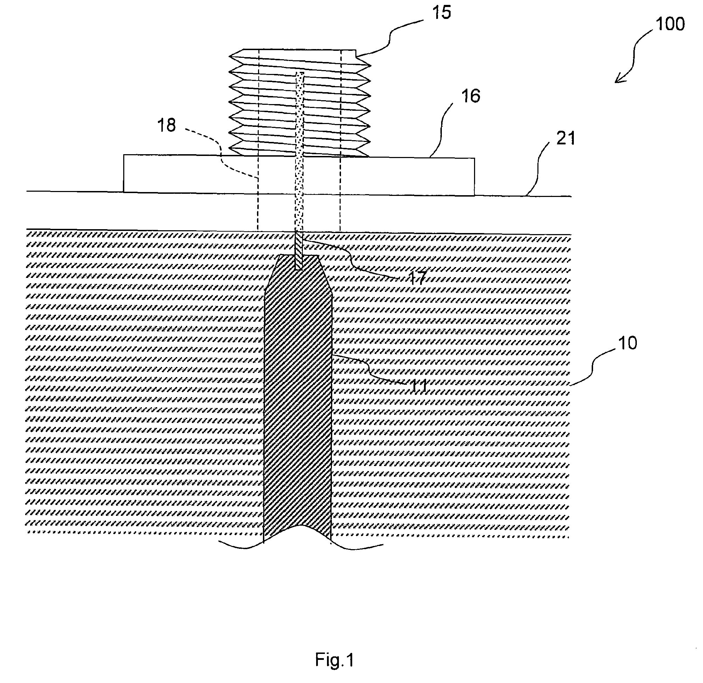

Fig. 1 is a top view of an electronic circuit 100 for explaining an embodiment of the present invention as an example. In Fig. 1, 10 is a substrate made of a dielectric, 11 is a micro-strip line as a conductor line provided on the upper surface of the substrate 10, 15 is a coaxial connector connected to the end portion of the micro-strip line 11 in the direction of signal propagation, 16 is a metal flange for mounting the coaxial connector 15 onto a conductor wall, 17 is a center conductor of the coaxial connector 15, 18 is an inter-electrode dielectric surrounding the center conductor 17 of the coaxial connector 15, and 21 is a conductor wall to which the coaxial connector 15 is mounted.

In Fig. 1, the coaxial connector 15 is mounted to the conductor wall 21 through the metal flange 16 and the inter-electrode dielectric 18 is filled in through holes provided through the coaxial connector 15 and the conductor wall 21. The center conductor 17 passes through the inter-electrode dielectric 18 at the center thereof and is connected to the micro-strip line 11. The conductor wall 21 and the metal flange 16 are connected to the ground of the substrate 10.

The micro-strip line is constituted by a ground formed on one surface of the substrate made of a dielectric and a conductor line as a distributed constant line formed on the other surface thereof from the ground. The set impedance of the micro-strip line is determined by the thickness of the conductor line, the line width of the conductor line, the thickness of the substrate and the permittivity of the dielectric constituting the substrate. When the inputting/outputting coaxial connector 15 is connected to the micro-strip line 11 as illustrated in Fig. 1, the impedance of the micro-strip line 11 is reduced due to the induction between the conductor wall 21 to which the coaxial connector 15 is mounted and the micro-strip line 11, at the portion of the micro-strip line 11 near the coaxial connector 15.

On the other hand, the specific line width of the micro-strip line 11 is determined by the thickness of the conductor line, the thickness of the substrate, and the permittivity of the dielectric constituting the substrate, for a desired set impedance. The set impedance is increased with decreasing line width of the micro-strip line.

Therefore, the line width of the micro-strip line 11 is reduced at the portion thereof near the conductor wall 21 to compensate for the reduction of the impedance of the micro-strip line 11 due to the induction. In order to reduce the line width, the line width may be either straightly reduced as illustrated in Fig. 1 or reduced along a gentle curve such as an arc. Further, the present invention is not limited to the reduction of the line width in an axisymmetric manner in the direction of signal propagation.

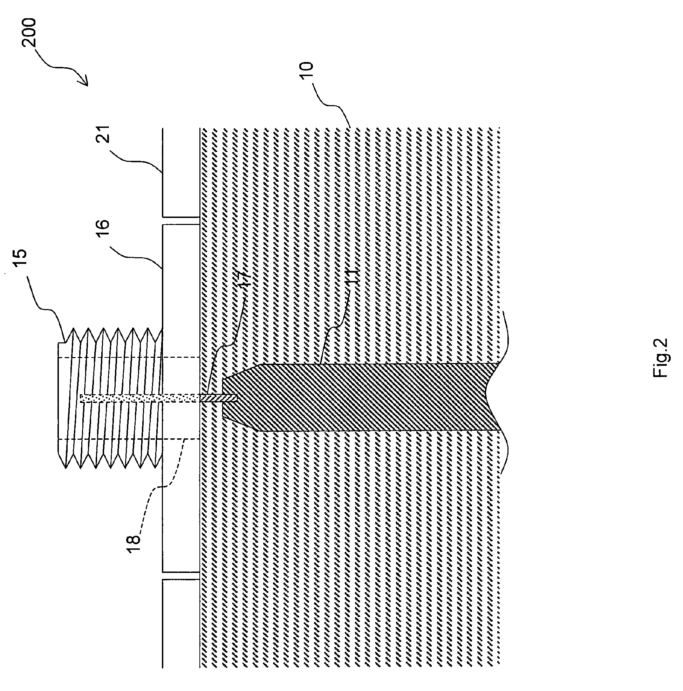

Fig. 2 is a top view of an electronic circuit 200 for explaining another embodiment of the present invention as an example. In Fig. 2, the same reference symbols as those in Fig. 1 represent the same meanings. The electronic circuit 200 is different from that in Fig. 1 in that the metal flange 16 of the coaxial connector 15 is mounted to the conductor wall 21, the substrate 10 or a case (not shown) such that the metal flange 16 is in contact with the substrate 10. In any of the cases, the metal flange 16 is connected to the ground of the substrate 10. In this case, the metal flange 16 functions as a conductor wall and the impedance of the micro-strip line 11 is reduced at the portion thereof near the metal flange 16, due to the induction with the metal flange 16.

Therefore, the line width of the micro-strip line 11 is reduced at the portion thereof near the metal flange 16 to compensate for the reduction of the impedance of the micro-strip line 11 due to the induction. In order to reduce the line width, the line width may be either straightly reduced as illustrated in Fig. 2 or reduced along a gentle curve such as an arc. Further, the present invention is not limited to the reduction of the line width in an axisymmetric manner in the direction of signal propagation.

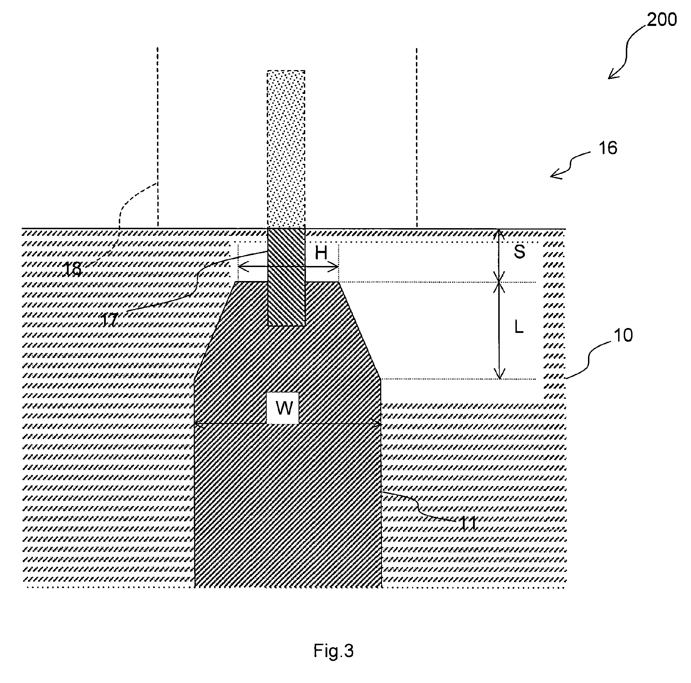

Fig. 3 is a top view illustrating, in an enlarged manner, the portion at which the micro-strip line 11 illustrated in Fig. 2 and the center conductor 17 of the coaxial connector 15 are connected to each other. The same reference symbols as those in Fig. 2 represent the same meanings. The specific line width of the micro-strip line 11 which is determined by a desired set impedance (hereinafter, "the specific line width of the micro-strip line 11 which is determined by a desired set impedance" will be abbreviated to "the specific line width of the micro-sprit line") is W, the line width of the end portion of the micro sprit line 11 is H, the distance between the end portion of the micro-sprit line 11 and the position at which the reduction of the line width on the micro-sprit line 11 is started is L and the distance between the end portion of the micro-sprit line 11 and the metal flange 16 is S.

In order to compensate for the reduction of the impedance of the micro-strip line 11 due to the induction with the metal flange 16, it is preferable that the line width H of the end portion of the micro-strip line 11 is reduced to equal to or less than 90% of the specific line width W of the micro-strip line 11. This is the amount required for compensating for the reduction of the impedance of the micro-strip line 11. However, it has been empirically proven that, if the line width is reduced to be smaller than 80% of the specific line width W of the micro-strip line 11, this will cause over-compensation for the impedance reduction of the micro-strip line 11. Accordingly, it is preferable that the line width H falls within the range which satisfies the following equation.

$$0.9 \times W \geq H \geq 0.8 \times W \quad (1)$$

While the line width of the micro-strip line 11 is reduced in an axisymmetric manner in the direction of signal propagation in Fig. 3, the present invention is not limited to reduction in an axisymmetric manner.

The distance L between the end portion of the micro-sprit line 11 and the position at which the reduction of the line width of the micro-strip line 11 is started is preferably equal to or greater than one-half of the difference between the specific line width W of the micro-strip line 11 and the line width H of the end portion of the micro-strip line. Accordingly, it is preferable that the distance L falls within the range which satisfies the following equation.

$$L \geq (W-H)/2 \quad (2)$$

Namely, the distance between the end portion of the micro-sprit line 11 and the position at which the reduction of the line width of the micro-strip line 11 is started is preferably equal to or greater than one-half of the amount of reduction of the line width of the micro-strip line 11. Since the impedance of the micro-strip line 11 is reduced as it becomes close to the metal flange 16, the line width of the micro-strip line 11 is gradually reduced to compensate for the reduction of the impedance.

Further, the greater the distance L between the end portion of the micro-sprit line 11 and the position at which the reduction of the line width of the micro-strip line 11 is started, the more preferable. Accordingly, it is preferable that the distance L between the end portion of the micro-sprit line 11 and the position at which the reduction of the line width of the micro-strip line 11 is started falls within the range which satisfies the following equation with respect to the specific line width W of the micro-strip line 11.

$$L \geq W \quad (3)$$

Namely, the distance between the end portion of the micro-sprit line 11 and the position at which the reduction of the line width of the micro-strip line 11 is started is preferably equal to or greater than the aforementioned specific line width of the micro-strip line 11.

Since the impedance of the micro-strip line 11 is significantly reduced due to induction at the region in which the micro-strip line 11 becomes close to the metal flange 16, it is preferable that a gap is provided between the end portion of the micro-strip line 11 and the metal flange 16 so that the distance S between the end portion of the micro-strip line 11 and the metal flange 16 is equal to or greater than 3% of the specific line width W of the micro-strip line 11. This is the amount required for preventing significant reduction of the impedance. However, if the distance is increased to be greater than 10 %, this will cause impedance mismatching. Accordingly, it is preferable that the distance S falls within the range which satisfies the following equation.

$$0.10 \times W \geq S \geq 0.03 \times W \quad (4)$$

While, in Fig. 3, there has been exemplified a case where the micro-strip line 11 becomes close to the metal flange 16, the present invention may be similarly applied to cases where the micro sprit line 11 becomes close to the conductor wall.

As previously described, with the electronic circuits according to the embodiments of the present invention, when the conductor line becomes close to the conductor wall, the line width of the conductor line is reduced to be smaller than the specific line width of the conductor line to compensate for the reduction of the impedance. While, in the embodiments of the present invention, the coaxial connector has been exemplified as a connector, the present invention is not limited to a coaxial connector.

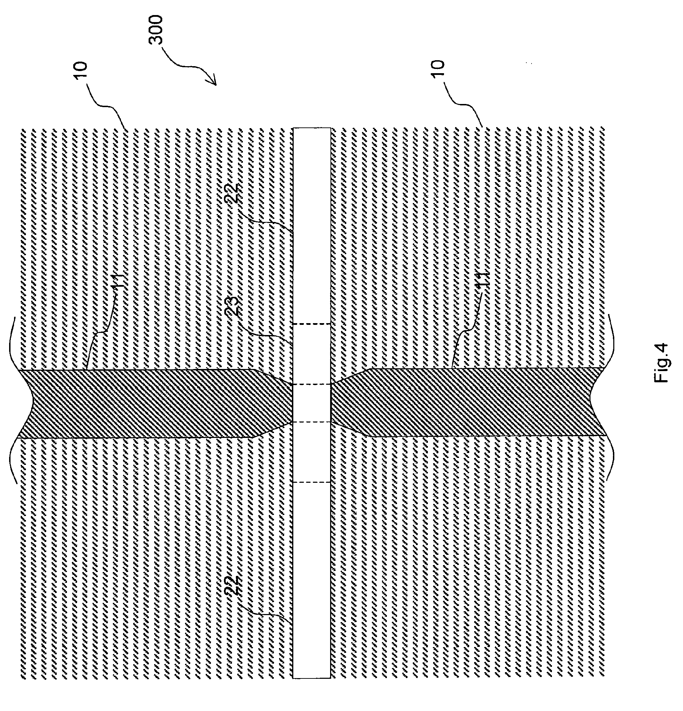

Next, there will be described an electronic circuit partitioned by a conductor wall. Fig. 4 is a top view of an electronic circuit 300 for explaining another embodiment of the present invention. In Fig. 4, 10 is a substrate made of a dielectric, 11 is a micro-strip line as a conductor line provided on the upper surface of the substrate 10, 22 is a conductor wall straddling the conductor line 11, and 23 is a through hole provided through the conductor wall 22.

In Fig. 4, the micro-strip line 11 provided on the upper surface of the substrate 10 passes through the through hole 23 provided through the conductor wall 22. As previously described, the impedance of the micro-strip line 11 is reduced at the portion thereof near the conductor wall 22, due to the induction between the micro-strip line 11 and the conductor wall 22. On the other hand, the set impedance is increased as line width of the micro-strip line 11 is reduced.

Therefore, the line width of the micro-strip line 11 is gradually reduced to be smaller than the specific line width of the micro-strip line 11 which becomes close to the conductor wall 22 while the line width of the portion of the micro-strip line 11 which is straddled by the conductor wall 22 is maintained at a constant value, so as to compensate for the reduction of the impedance of the micro-strip line 11 due to induction. The line width of the micro-strip line 11 may be either straightly reduced as illustrated in Fig. 4 or reduced along a gentle curve such as an arc. Further, the present invention is not limited to reduction of the line width in an axisymmetric manner in the direction of signal propagation.

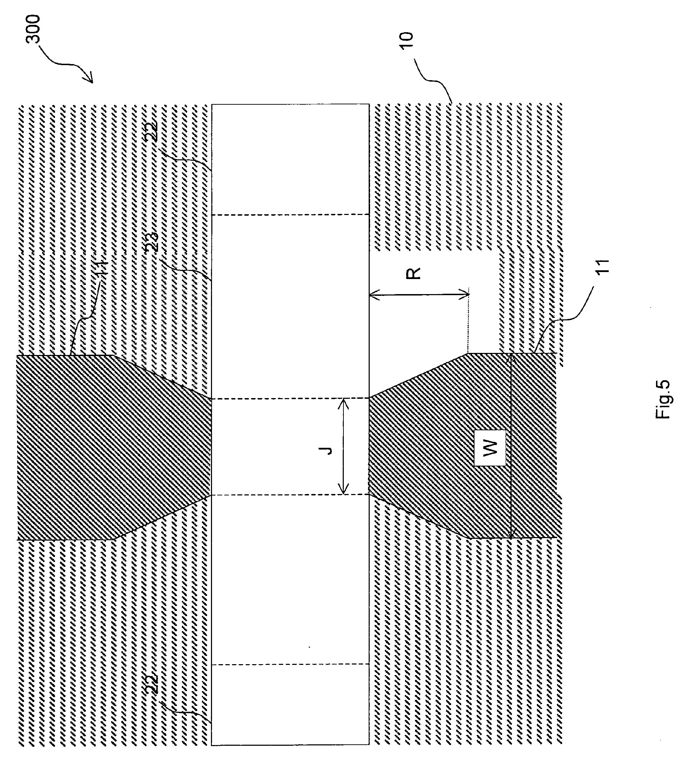

Fig. 5 is a top view illustrating, in an enlarged manner, the portion of the micro-strip line 11 illustrated in Fig. 4 which passes through the through hole 23 provided through the conductor wall 22. The same reference symbols as those in Fig. 4 represent the same meanings. The specific line width of the micro-strip line 11 is W, the line width of the portion of the micro-strip line 11 which is straddled by the conductor wall 22 is J, and the distance between the conductor wall 22 and the position at which the reduction of the line width of the micro-strip line is started is R.

In order to compensate for the reduction of the impedance of the micro-strip line 11 due to the induction with the conductor wall 22, it is preferable that the line width of the portion of the micro-strip line 11 which is straddled by the conductor wall 22 is set to equal to or smaller than 90% of the specific line width W of the micro-strip line 11. This is the amount required for compensating for the reduction of the impedance of the micro-strip line 11. However, it has been empirically proven that, if the line width is reduced to be smaller than 80% of the specific line width W of the micro-strip line 11, this will cause over-compensation for the impedance reduction. Accordingly, it is preferable that the aforementioned line width falls within the range which satisfies the following equation.

$$0.9 \times W \geq J \geq 0.8 \times W \quad (5)$$

While the line width of the micro-strip line 11 is reduced in an axisymmetric manner in the direction of signal propagation in Fig. 5, the present invention is not limited to reduction in an axisymmetric manner.

The distance R between the conductor wall 22 and the position at which the reduction of the line width of the micro-strip line 11 is started is preferably equal to or greater than one-half of the difference between the specific line width W of the micro-strip line 11 and the line width J of the portion of the micro-trip line 11 which is straddled by the conductor wall 22. Accordingly, it is preferable that the distance R falls within the range which satisfies the following equation.

$$R \geq (W-J)/2 \quad (6)$$

Namely, the distance between the conductor wall 22 and the position at which the reduction of the line width of the micro-strip line 11 is started is preferably equal to or greater than one-half of the amount of reduction of the line width of the micro-strip line 11. Since the impedance of the micro-strip line 11 is reduced as the micro-strip line becomes close to the conductor wall 22, the line width of the micro-strip line 11 is gradually reduced to compensate for the reduction of the impedance.

Further, the greater the distance R between the conductor wall 22 and the position at which the reduction of the line width of the micro-strip line 11 is started, the more preferable. Accordingly, it is preferable that the distance R between the conductor wall 22 and the position at which the reduction of the line width of the micro-strip line 11 is started falls within the range which satisfies the following equation, with respect to the specific line width W of the micro-strip line 11.

$$R \geq W \quad (7)$$

Namely, the distance between the conductor wall 22 and the position at which the reduction of the line width is started is preferably equal to or greater than the specific line width of the micro-strip line which is determined by the aforementioned set impedance of the micro-strip line.

As previously described, with the electronic circuit according to the embodiment of the present invention, when the conductor line passes through the through hole provided through the conductor wall, the line width of the conductor line is reduced to be smaller than the specific line width of the conductor line to compensate for the reduction of the impedance.

While there have been described embodiments where a micro-strip line becomes close to a conductor wall, the same effects can be obtained when a coplanar line is employed instead of a micro-strip line. Such a coplanar line is employed for a higher signal frequency region similarly to micro-strip lines, and the specific line width of a coplanar line is determined by the thickness of the conductor line, the thickness of the substrate and the permittivity of the dielectric constituting the substrate, for a desired set impedance. Similarly to a micro-strip line, the impedance of a coplanar line is increased as line width of the coplanar line is reduced. Accordingly, by reducing the line width of such a coplanar line, it is possible to offer a higher effect of compensating for the impedance reduction as aforementioned.

The present invention can alleviate the degradation of signal propagating characteristics due to the influences of the metal flanges of connectors or conductor walls, even when conductor lines formed on the upper surface of a substrate are connected to the connectors or pass through through-holes provided through the conductor walls.

The electronic circuits according to the present invention can be utilized in radio units which utilize high-frequency waves, coaxial CATV amplifiers which utilize carrier waves and adjustment thereof.

**Claims**

1. An electronic circuit comprising:

    a substrate made of a dielectric;
    a conductor line provided on the upper surface of said substrate;

a connector connected to the end portion of said conductor line in the direction of signal propagation; and a conductor wall to which said connector is mounted;

wherein the line width of said conductor line is gradually reduced to be smaller than the specific line width of said conductor line which is determined by a set impedance of said conductor line from a predetermined position as said conductor line becomes close to the said end portion.

2. The electronic circuit according to Claim 1, wherein a gap is provided between said end portion and said conductor wall such that the distance between said end portion and said conductor wall is in the range of 3% or more to 10% or less of the specific line width of said conductor line which is determined by the set impedance of said conductor line.

3. The electronic circuit according to Claim 1 or 2, wherein the line width of said end portion of said conductor line is within the range of 80% or more to 90% or less of the specific line width of said conductor line which is determined by the set impedance of said conductor line.

4. The electronic circuit according to any one of Claims 1 to 3, wherein the distance between said end portion of said conductor line and said predetermined position is equal to or greater than one-half of the difference between the specific line width of said conductor line which is determined by the set impedance of said conductor line and the line width of said end portion.

5. An electronic circuit comprising:

a substrate made of a dielectric;
a conductor line provided on the upper surface of said substrate ; and
a conductor wall straddling said conductor line;

wherein the line width of said conductor line is gradually reduced to be smaller than the specific line width of said conductor line which is determined by a set impedance of said conductor line from a predetermined position as said conductor line becomes close to said conductor wall and the portion of said conductor line which is straddled by said conductor wall has a constant line width.

6. The electronic circuit according to Claim 5, wherein said conductor line has a line width within the range of 80% or more to 90% or less of the specific line width of said conductor line which is determined by the set impedance of said conductor line, at its portion straddled by said conductor wall.

7. The electronic circuit according to Claim 5 or 6, wherein the distance between said conductor wall and said predetermined position is equal to or greater than one-half of the difference between the specific line width of said conductor line which is determined by the set impedance of said conductor line and the line width of the portion of said conductor line which is straddled by said conductor wall.

Fig.1

EP 1 708 550 A1

Fig.2

EP 1 708 550 A1

Fig.3

EP 1 708 550 A1

Fig.4

EP 1 708 550 A1

Fig.5

European Patent
Office

**EUROPEAN SEARCH REPORT**

Application Number

EP 06 00 5189

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 376 751 A (SUMITOMO ELECTRIC INDUSTRIES, LTD) 2 January 2004 (2004-01-02) * paragraphs [0015] - [0019]; figures 1,2,4 * | 1-7 | INV. H05K1/02 |
| X | US 5 451 818 A (CHAN ET AL) 19 September 1995 (1995-09-19) * column 3, lines 41-57; figure 2 * | 5-7 | |
| X | US 4 259 684 A (DEAN ET AL) 31 March 1981 (1981-03-31) * column 5, lines 4-18; figures 2,4 * | 5-7 | |
| A | PATENT ABSTRACTS OF JAPAN vol. 1997, no. 01, 31 January 1997 (1997-01-31) & JP 08 250912 A (JAPAN RADIO CO LTD), 27 September 1996 (1996-09-27) * abstract * | 1-4 | |
| A | US 4 626 805 A (JONES ET AL) 2 December 1986 (1986-12-02) * column 1, line 65 - column 2, line 8; figure 1 * | 1-4 | TECHNICAL FIELDS SEARCHED (IPC) H05K H01P H01L |
| A | EP 0 444 820 A (RAYTHEON COMPANY) 4 September 1991 (1991-09-04) * page 5, line 47 - page 6, line 11; figure 1 * | 5-7 | |
| A | PATENT ABSTRACTS OF JAPAN vol. 2003, no. 11, 5 November 2003 (2003-11-05) -& JP 2003 218481 A (MITSUBISHI ELECTRIC CORP), 31 July 2003 (2003-07-31) * abstract * | | |

The present search report has been drawn up for all claims

| Place of search | Date of completion of the search | Examiner |
|---|---|---|
| Munich | 7 July 2006 | Batev, P |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...............................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 06 00 5189

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2006

| Patent document cited in search report | | Publication date | Patent family member(s) | | Publication date |
|---|---|---|---|---|---|
| EP 1376751 | A | 02-01-2004 | CN<br>WO<br>US | 1460309 A<br>02082578 A1<br>2004014341 A1 | 03-12-2003<br>17-10-2002<br>22-01-2004 |
| US 5451818 | A | 19-09-1995 | NONE | | |
| US 4259684 | A | 31-03-1981 | NONE | | |
| JP 08250912 | A | 27-09-1996 | NONE | | |
| US 4626805 | A | 02-12-1986 | CA<br>DE<br>EP<br>JP<br>JP<br>JP | 1240373 A1<br>3675975 D1<br>0200291 A2<br>2101792 C<br>7114323 B<br>61251059 A | 09-08-1988<br>17-01-1991<br>05-11-1986<br>22-10-1996<br>06-12-1995<br>08-11-1986 |
| EP 0444820 | A | 04-09-1991 | JP | 4216201 A | 06-08-1992 |
| JP 2003218481 | A | 31-07-2003 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Microwave Filers, Impedance-Matching Networks, And Coupling Structures. ARTECH HOUSE BOOKS, 1980, 475